(19) **Europäisches Patentamt / European Patent Office / Office européen des brevets**

(11) **EP 3 671 190 B1**

(12) **FASCICULE DE BREVET EUROPEEN**

(45) Date de publication et mention
de la délivrance du brevet:
**09.11.2022 Bulletin 2022/45**

(21) Numéro de dépôt: **19218797.9**

(22) Date de dépôt: **20.12.2019**

(51) Classification Internationale des Brevets (IPC):
**G01N 23/20058** [(2018.01)]

(52) Classification Coopérative des Brevets (CPC):
**G01N 23/20058;** H01J 37/2955

(54) **MÉTHODE D'IMAGERIE À RÉSOLUTION SPATIALE ATOMIQUE**

BILDGEBUNGSMETHODE MIT ATOMARER AUFLÖSUNG

IMAGING METHOD WITH ATOMIC SPATIAL RESOLUTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.12.2018 FR 1874055**

(43) Date de publication de la demande:
**24.06.2020 Bulletin 2020/26**

(73) Titulaire: **Commissariat à l'énergie atomique
et aux énergies alternatives
75015 Paris (FR)**

(72) Inventeur: **GUEDJ, Cyril
38054 Grenoble Cedex 09 (FR)**

(74) Mandataire: **Brevalex
95, rue d'Amsterdam
75378 Paris Cedex 8 (FR)**

(56) Documents cités:
- **J. GONNISSEN ET AL: "Detecting and locating
  light atoms from high-resolution STEM images:
  The quest for a single optimal design",
  ULTRAMICROSCOPY, vol. 170, 1 novembre 2016
  (2016-11-01), pages 128-138, XP055640120, NL
  ISSN: 0304-3991, DOI:
  10.1016/j.ultramic.2016.07.014**
- **JIANG YI ET AL: "Electron ptychography of 2D
  materials to deep sub-ångström resolution",
  NATURE, MACMILLAN JOURNALS LTD., ETC.|,
  LONDON, vol. 559, no. 7714, 18 juillet 2018
  (2018-07-18), pages 343-349, XP036544230, ISSN:
  0028-0836, DOI: 10.1038/S41586-018-0298-5
  [extrait le 2018-07-18]**
- **YANG H ET AL: "4D STEM: High efficiency phase
  contrast imaging using a fast pixelated detector",
  JOURNAL OF PHYSICS: CONFERENCE SERIES,
  INSTITUTE OF PHYSICS PUBLISHING, BRISTOL,
  GB, vol. 644, no. 1, 12 octobre 2015 (2015-10-12),
  page 12032, XP020289644, ISSN: 1742-6596, DOI:
  10.1088/1742-6596/644/1/012032 [extrait le
  2015-10-12]**
- **CYRIL GUEDJ ET AL: "Atomistic Modelling and
  Simulation of Transmission Electron Microscopy
  Images: Application to Intrinsic Defects of
  Graphene :", PROCEEDINGS OF 8TH
  INTERNATIONAL CONFERENCE ON
  SIMULATION AND MODELING
  METHODOLOGIES, TECHNOLOGIES AND
  APPLICATIONS, 31 juillet 2018 (2018-07-31),
  pages 15-24, XP055640360, DOI:
  10.5220/0006829200150024 ISBN:
  978-989-7583-23-0**

## Description

## DOMAINE TECHNIQUE ET ÉTAT DE LA TECHNIQUE ANTÉRIEURE

La présente invention se rapporte à une méthode d'imagerie à résolution spatiale atomique, permettant en particulier de cartographier et analyser des éléments chimiques légers, tels que l'hydrogène. La méthode permet également de cartographier et analyser les lacunes.

Dans un grand nombre de domaines, il est souhaitable de réaliser des cartographies chimiques élémentaires d'échantillons. En effet les propriétés physiques des nanostructures et des interfaces sont contrôlées par la position et la nature des atomes. Par exemple, il peut être très intéressant de procéder à l'analyse élémentaire de l'hydrogène et des lacunes présentes, afin de corréler leur présence avec les propriétés physiques, telles que des propriétés mécaniques, électriques, optiques, magnétiques, etc. des matériaux et dispositifs analysés. Par exemple, dans le domaine du nucléaire, on souhaite étudier la fragilisation de métaux par l'hydrogène, et/ou le vieillissement et la fragilisation de gaines causée par la formation d'hydrures favorisant la propagation de fissures.

Dans le domaine de la production et du stockage de l'hydrogène, il est important d'étudier à l'échelle nanométrique la tenue des matériaux utilisés, afin d'analyser les éventuelles mécanismes de fuites d'hydrogène, par exemple lors de phénomènes de vieillissements.

Dans le domaine du filtrage des gaz avec des membranes à base de graphène, il est nécessaire d'étudier les liens entre la nanostructure et les phénomènes de perméation.

Dans le domaine des semi-conducteurs, il est nécessaire d'étudier le lien entre les performances, la fiabilité électrique, et la présence d'hydrogène et de lacunes, notamment aux interfaces critiques.

Or il existe très peu de méthodes d'imagerie permettant de cartographier et d'analyser l'hydrogène.

Une méthode consiste à utiliser une microsonde nucléaire, dont le fonctionnement se base sur l'interaction nucléaire d'un faisceau d'hélions avec l'échantillon. La méthode d'analyse directe permettant de cartographier l'hydrogène avec une grande sensibilité est la méthode communément désignée suivant l'acronyme ERDA correspondant à la terminologie anglaise "Elastic Recoil Détection Analysis". Cette méthode est décrite dans le document « Below-surface behavior of hydrogen studied by nuclear reaction analysis" K. Fukutani, Curr. Opin. Solid State Mater. Sci. 6, 153-161 (2002). Cette méthode requiert un vide poussé et l'utilisation de grands instruments dont l'accès est limité.

Il existe d'autres méthodes permettant de caractériser l'hydrogène, mais celles-ci sont généralement destructives et ne permettent pas de cartographier l'hydrogène dans l'échantillon avec une résolution spatiale décapicométrique.

Une autre méthode utilise la microscopie électronique en transmission. Une détection de l'hydrogène sur du graphène a été réalisée mais la mise en œuvre est très délicate et les images publiées ne donnent pas une résolution atomique pour le graphène. Cette méthode est décrite dans le document "Imaging and dynamics of light atoms and molecules on graphene" J. C. Meyer, C. O. Girit, M. F. Crommie, A. Zettl, Nature 454, 319-322 (2008).

Une autre méthode d'imagerie à résolution spatiale atomique est décrite dans le document "Detecting and locating light atoms from high-resolution STEM images: The quest for a single optimal design", J. Gonnissen, et al., Ultramicroscopy 170,, p. 128-138 (2016).

## EXPOSÉ DE L'INVENTION

C'est par conséquent un but de la présente invention d'offrir une nouvelle méthode d'imagerie à résolution spatiale atomique offrant une sensibilité à tous les éléments de la classification périodique, notamment permettant de cartographier l'hydrogène et également les lacunes.

Le but énoncé ci-dessus est atteint par une méthode d'imagerie électronique d'un échantillon dans un matériau donné et comportant au moins un élément à imager, comportant les étapes suivantes :

- acquisition de clichés de diffraction de l'échantillon, c'est-à-dire des images du réseau réciproque, obtenus par microscopie électronique en transmission ou en réflexion, avec balayage du faisceau,
- choix d'une pluralité de détecteurs élémentaires,
- pour chaque détecteur élémentaire, calcul théorique des images dans l'espace réel qui seraient obtenues avec un échantillon décrit par un modèle atomistique, c'est-à-dire par la position théorique et la nature de tous ses atomes,
- sélection des images calculées offrant une bonne visibilité dudit élément donné,
- combinaison desdites images pour former une image de l'échantillon.

La méthode d'imagerie selon l'invention acquiert une série de clichés de diffraction par microscopie à balayage avec un seul détecteur, par exemple par la technique 4D-Stem qui sera détaillée ci-dessous.

Ensuite la méthode prévoit de choisir des détecteurs élémentaires dans l'espace réciproque qui seraient le plus susceptibles de détecter l'élément donné, et calcule les images dans l'espace réel qui seraient fournies par chacun de ces détecteurs élémentaires. Les détecteurs élémentaires sont des détecteurs numériques et non réels. La forme des détecteurs élémentaires est choisie de sorte à être incluse dans le détecteur physique utilisé pour l'acquisition des données de diffraction.

Des images parmi les images calculées sont sélectionnées, par exemple celles sur lesquelles l'élément donné engendre un fort contraste dans son voisinage dans l'image calculée dans l'espace réel.

Dans la présente demande, on entend par forte contraste, un contraste égal à au moins le double du contraste trouvé dans le bruit, le contraste dans le bruit étant égal à :

$$\frac{(signal\ maximal\ du\ bruit - signal\ minimal\ du\ bruit)}{(signal\ \min\ du\ bruit + signal\ \max\ du\ bruit)/2}$$

Le voisinage de l'élément donné est la zone comprenant tous les points situés à distance de l'élément donnée, qui inférieure à 3 fois le rayon atomique de l'élément.

Ces images sont ensuite combinées pour former l'image finale.

La sélection d'images et la combinaison d'images dans l'espace réel revient à élaborer un détecteur virtuel optimisé qui serait composé d'une combinaison mathématique d'une sélection des détecteurs élémentaires dans l'espace réciproque. Ce détecteur virtuel présente une sensibilité à l'élément donné augmentée et une meilleure résolution spatiale. En outre, il présente l'avantage de collecter sélectivement le maximum de contraste utile disponible.

Les détecteurs élémentaires choisis sont par exemple un ou des détecteurs annulaires, un ou des détecteurs en forme de disque, un ou des détecteurs en forme de surface délimitée par une ellipse ou par une intersection d'ellipses, un ou des détecteurs comportant un ensemble de pixels carrés...

La méthode simule mathématiquement la présence de ces détecteurs élémentaires qui peuvent être physiquement non réalisables, pour calculer les images.

En d'autres termes, on choisit les détecteurs élémentaires dans l'espace réciproque qui seraient les plus performants pour cartographier l'élément chimique dans le matériau, dans des conditions et des réglages de microscopes donnés, afin de pouvoir calculer des images dans l'espace réel qui seront ensuite combinées pour former l'image définitive.

La méthode selon l'invention n'utilise pas des images obtenues directement par un détecteur physique donné qui résulte d'un compromis pour être adapté à un grand nombre d'éléments à analyser et qui est contraint par les limitations technologiques de réalisation, notamment en termes de tenue mécanique, mais construit les images à partir des informations physiques fournies par les clichés de diffraction de l'échantillon et des détecteurs numériques élémentaires qui permettent de convertir le signal de diffraction de l'espace réciproque en image dans l'espace réel. Ensuite la méthode sélectionne les images les plus exploitables, par exemple présentant le plus grand contraste entre le matériau et l'élément chimique, ces images sont ensuite combinées pour former l'image finale.

Le détecteur virtuel peut être conçu en tenant compte d'un grand nombre de paramètres, par exemple l'épaisseur de l'échantillon, les réglages du microscope électronique à transmission, de l'orientation de l'échantillon. Le détecteur est donc spécialement adapté à la détection d'un échantillon et d'un élément donné, pour chaque réglage de microscope.

La méthode d'imagerie détermine ce détecteur virtuel optimisé pour chaque couple de matériau et d'élément chimique donné, en fonction des paramètres de réglage du microscope.

Dans le cas d'un échantillon comportant un matériau et plusieurs éléments chimiques donnés, la méthode prévoit de mettre au point un détecteur virtuel optimisé pour chaque élément chimique à partir des mêmes clichés de diffraction et de modèles atomistiques pour chaque couple matériau - élément chimique. Le temps pour imager l'échantillon est réduit car la méthode ne nécessite qu'une seule étape d'acquisition de clichés de diffraction, donc les risques d'endommagement de l'échantillon par le balayage du faisceau sont réduits. Le traitement des données avec les détecteurs virtuels optimisés sélectifs permet ensuite de traiter chaque élément séparément.

Le détecteur virtuel optimisé mis au point pour un échantillon comportant un matériau donné et un élément chimique donné peut être enregistré, puis ensuite réutilisé pour imager un échantillon comportant le même matériau donné et le même élément chimique donné dans les mêmes conditions expérimentales, telles que les réglages du microscope lors de l'acquisition de clichés de diffraction.

La méthode selon l'invention permet de détecter les éléments chimiques légers tels que les atomes d'hydrogène, elle permet également de détecter les lacunes.

L'élaboration du détecteur virtuel peut très avantageusement intégrer des conditions particulières appliquées à l'échantillon lors de l'acquisition des clichés de diffraction, telles que l'application d'une polarisation à l'échantillon, de la génération d'un environnement gazeux sous pression...

La présente invention a alors pour objet une méthode d'imagerie d'au moins un élément donné dans un matériau donné d'un échantillon comportant :

a) l'acquisition de clichés de diffraction d'une pluralité d'emplacements d'une zone donnée de l'échantillon par balayage au moyen d'un faisceau d'électrons ou de rayons X de la zone donnée,

b) la détermination d'un modèle atomistique entre l'élément donné et le matériau donné,

c) le choix d'une pluralité de détecteurs élémentaires en fonction du modèle atomistique,

d) le calcul, pour chaque détecteur élémentaire, des images théoriques, dans l'espace réel obtenues à partir du modèle atomistique avec élément et à partir du modèle atomistique sans élément pour un réglage physique instrumental donné et des données de clichés de diffraction acquises à l'étape a),

e) le calcul pour chaque détecteur élémentaire de la différence entre les images dans l'espace réel obtenues à partir du modèle atomistique avec élément et du modèle atomistique sans élément, dites premières images,

f) la sélection d'images parmi les premières images, sur lesquelles il existe un fort contraste au voisinage de l'élément donné,

g) La combinaison des images sélectionnées pour former une deuxième image de l'élément donné dans le matériau donné.

De manière avantageuse, la méthode d'imagerie comporte à l'étape e), l'étape de calcul de troisièmes images résultant de la soustraction des images calculées à partir du modèle atomistique sans élément aux images calculées à partir du modèle atomistique avec élément, et le calcul de quatrièmes images résultant de la soustraction des images calculées à partir du modèle atomistique avec élément aux images calculées à partir du modèle atomistique sans élément, et dans lequel l'étape de sélection est une sélection parmi les troisièmes et quatrièmes images.

De préférence, l'étape de combinaison combine les valeurs absolues des contrastes de toutes les images sélectionnées.

Par exemple, les détecteurs élémentaires choisis sont des détecteurs annulaires d'acceptance angulaire comprise entre nxl0 mrd et (n+1)$\times$10 mrd.

Dans le cas d'un échantillon dont on souhaite imager plusieurs éléments, les étapes b) à g) peuvent être répétées pour chaque élément de l'échantillon.

L'élément peut être un élément chimique du tableau périodique ou une lacune neutre ou une lacune chargée.

Selon une caractéristique additionnelle, la méthode d'imagerie peut comporter l'étape de cartographie supplémentaire d'au moins une autre propriété physique de l'échantillon. L'étape de cartographie supplémentaire peut être une étape de cartographie des champs électrique et/ou des champs magnétiques dans l'échantillon, et un détecteur virtuel annulaire à quatre quadrants est déterminé numériquement.

Dans un exemple avantageux, la méthode d'imagerie comporte après l'étape d), le calcul d'une image à partir d'un détecteur aveugle à l'élément, et le calcul de la différence normalisée entre l'image obtenue à l'étape g) qui est hypersensible à l'élément et l'image aveugle à cet élément, et/ou es détecteurs élémentaires sont choisis de sorte à être peu sensibles à l'épaisseur de l'échantillon.

Par exemple, l'acquisition de l'étape a) est réalisée par microscopie électronique en transmission.

L'élément donné peut être l'hydrogène ou une lacune neutre ou une lacune chargée.

Avantageusement, la méthode d'imagerie comporte l'intégration de filtres dans les détecteurs numériques élémentaires.

La présente invention a également pour objet une méthode d'imagerie différentielle comportant :

- la formation d'une deuxième image par la mise en œuvre de la méthode selon l'invention,
- l'application d'au moins une condition modifiant au moins ladite zone de l'échantillon,
- la formation d'une autre deuxième image de ladite zone par la mise en œuvre de la méthode selon l'invention,
- l'analyse différentielle des deux deuxièmes images.

Par exemple, la condition appliquée à l'échantillon est choisie parmi une polarisation électrique, un environnement gazeux et une température.

La présente invention a également pour objet une méthode d'élaboration d'un détecteur d'imagerie d'un élément donné sur ou dans un matériau donné dans des conditions expérimentales données comportant les étapes :

a') l'acquisition de clichés de diffraction d'une pluralité d'emplacements d'une zone donnée de l'échantillon par balayage au moyen d'un faisceau d'électrons ou de rayons X de la zone donnée dans lesdites conditions expérimentales données,

b') la détermination d'un modèle atomistique entre l'élément chimique donné et le matériau donné,

c') le choix d'une pluralité de détecteurs élémentaires en fonction du modèle atomistique,

d') le calcul de premières images de la zone donnée qui auraient été obtenues par la pluralité de détecteurs élémentaires choisis, à partir des clichés de diffraction et du modèle atomistique,

e') la sélection des détecteurs élémentaires ayant donnés par calcul les images parmi des images calculées issues des premières images, sur lesquelles il existe la meilleure visibilité de l'élément donné,

f') la combinaison des détecteurs élémentaires pour former un détecteur apte à imager l'élément donné dans le matériau donné.

## BRÈVE DESCRIPTION DES DESSINS

La présente invention sera mieux comprise sur la base de la description qui va suivre et des dessins en annexe sur lesquels :

La figure 1 est une représentation schématique d'un système permettant de mettre en œuvre une méthode d'acquisition de clichés de diffraction par 4D-stem.

La figure 2 est une représentation d'un modèle atomistique de la liaison entre un atome d'hydrogène et une surface en graphène, calculé avec le potentiel interatomique de type Brenner.

La figure 3 représente les images calculées au cours de la méthode d'imagerie selon l'invention dans le cas d'un échantillon de graphène contenant de l'hydrogène.

La figure 4 représente des images obtenues en soustrayant à des images de la figure 3 une image calculée sans hydrogène.

La figure 5 représente des images obtenues en soustrayant à une image calculée sans hydrogène les images de la figure 3.

La figure 6 est la somme de certaines images des figures 4 et 5.

La figure 7 est une comparaison entre une image obtenue avec la méthode selon l'invention et une image obtenue par HAADF, c'est-à dire avec un angle de collection annulaire dans l'espace réciproque compris entre 120 et 250 mrad.

## EXPOSÉ DÉTAILLÉ DE MODES DE RÉALISATION PARTICULIERS

La méthode d'imagerie décrite ci-dessous permet d'imager la présence d'un ou plusieurs éléments chimiques ou de lacunes dans un matériau d'un échantillon. La description ci-dessous décrira en détail l'imagerie de l'hydrogène dans un échantillon de graphène. On entend par « imager » ou « cartographier » dans la présente demande, la réalisation d'une ou plusieurs images montrant la localisation chimique de la ou des éléments chimiques ou de lacunes. Les images obtenues sont des images à l'échelle atomique.

Dans la description qui va suivre, le terme « matériau » désigne le matériau principal de l'échantillon et le terme « élément » désigne à la fois un élément chimique, une lacune et un nanopore enterré, que l'on souhaite cartographier sur ou dans le matériau de l'échantillon. L'élément est par exemple un contaminant.

Dans la description qui va suivre, les expressions « figure de diffraction », « cliché de diffraction », « images du réseau réciproque » et « images dans l'espace réciproque » sont utilisées indistinctement.

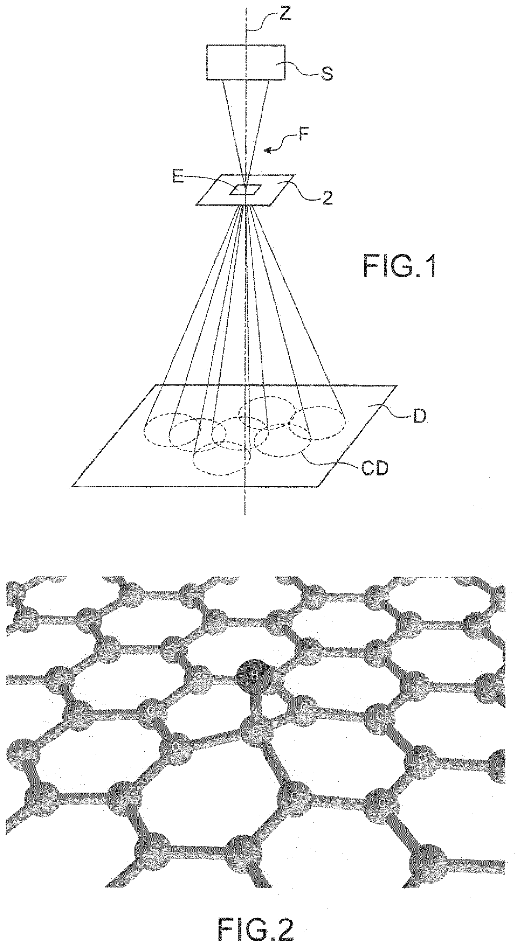

Sur la figure 1, on peut voir une représentation schématique d'une installation permettant d'acquérir les clichés de diffraction exploités par la méthode d'imagerie selon l'invention.

L'installation de la figure 1 comporte un microscope électronique en transmission à balayage ou STEM (Scanning Transmission Electron Microscope en terminologie anglo-saxonne) comportant une source d'électrons S et émettant un faisceau d'électrons désigné F le long de de la direction Z, un porte-échantillon 2 en aval de la source d'électrons de sorte que l'échantillon E est soit sur le passage des électrons et un détecteur D en aval de l'échantillon, collectant les clichés de diffraction dues à l'interaction entre les électrons du faisceau F et les atomes de échantillon E. Les électrons sont typiquement accélérés avec une tension comprise entre 20 keV et 1 MeV, mais les gammes les plus courantes sont comprises entre 60 et 300 kV. Le faisceau est focalisé avec un spot sur l'échantillon compris entre 0,1 nm et 10 nm et les détecteurs physiques actuels les plus courants ont une forme d'anneau (Dark field) ou de disque (Bright field).

En outre, le STEM est tel que le faisceau d'électrons est mobile afin de réaliser un balayage contrôlé des électrons sur une zone donnée de l'échantillon. Chaque cliché de diffraction est repéré en fonction de l'emplacement de zone scannée. On obtient alors une matrice de clichés de diffraction. On désigne cette méthode d'acquisition par méthode 4D-stem car elle permet d'acquérir une matrice 2D d'images de diffraction 2D. Cette méthode est par exemple décrite dans le document Electron ptychography of 2D materials to deep sub-ångsi-röm resolution », Yi Jiang et al., Nature. 2018 Jul; 559(7714): 343-349. doi: 10.1038/s41586-018-0298-5. Tous les critères usuels permettant la reconstruction 3D dans l'espace réel sont respectés, par exemple un recouvrement suffisant entre les images de diffraction lors de l'acquisition.

On peut également appliquer la méthode ISTEM (Imaging scanning transmission electron microscopy) décrite par exemple dans le document : A Realisation of Incoherent Imaging for Ultra-High Resolution TEM beyond the Classical Information Limit - Instrumentation and Methods - - Florian F. Krause and al - European Microscopy Congress -20 December 2016, et dans le document Conventional Transmission Electron Microscopy Imaging beyond the Diffraction and Information Limits", Phys. Rev Lett. 113, 096101(2014)

L'imagerie ISTEM combine le balayage du faisceau en mode STEM avec les réglages du microscope dans un mode d'imagerie CTEM conventionnelle. Elle permet d'acquérir des cartographies de diffraction (réseau réciproque de l'échantillon) avec des réglages de microscopes initialement conçus pour imager l'espace réel.

Les clichés de diffraction désignés CD sont schématisés sur le détecteur D.

En variante, l'acquisition des clichés de diffraction peut être réalisée par toute technique produisant des acquisitions d'images du réseau réciproque, par exemple par diffraction de rayons X (reciprocal space mapping), ou la technique de microscopie de photoélectrons dans l'espace réciproque k-PEEM (k-space PhotoEmission Electron Microscopy en terminologie anglo-saxonne).

De manière générale la méthode d'imagerie selon l'invention, qui est destinée à imager au moins un élément donné dans un matériau donné d'un échantillon, comporte :

- l'acquisition séquentielle d'images du réseau réciproque d'une zone donnée de l'échantillon (clichés de diffraction),
- la détermination d'un modèle atomistique entre l'élément et le matériau donné, i.e. la détermination de la position relative de tous les atomes, dont l'élément,

- le choix d'une pluralité de détecteurs élémentaires en fonction du modèle atomistique,
- le calcul des images dans l'espace réel obtenu pour chaque détecteur élémentaire, à partir d'un cliché de diffraction et du modèle atomistique,
- la sélection d'une ou plusieurs images sur lesquelles il existe la meilleure visibilité pour l'élément donné,
- la combinaison, par exemple additive ou soustractive, des images sélectionnées par l'étape précédente pour former l'image de l'élément donné dans le matériau donné.

L'acquisition de données et l'acquisition de clichés de diffraction sont synonymes dans la présente demande.

Pour l'acquisition, le diamètre de la sonde ou du faisceau est choisi le plus petit possible accessible par le microscope pour pouvoir résoudre la structure à l'échelle atomique. L'angle de convergence du faisceau est de préférence choisi selon la formule :

$$(4 \cdot \lambda / C_s)^{0,25} \cdot \P$$

où À représente la longueur d'onde des électrons et $C_s$ le coefficient d'aberration sphérique, soit un angle de convergence de 10 mrad pour une longueur d'onde de 2,57 pm obtenue avec des électrons de 200 kV. En pratique, on explorera par la simulation des angles de convergence dans la gamme comprise entre 0 mrad et le double de la convergence optimale soit [0-30] mrad.

La détermination du modèle atomistique peut se faire de la manière suivante. On peut utiliser les données les clichés de diffraction acquis à l'étape précédente. Pour ce faire, on calcule une image de type HRSTEM-HAADF à partir des acquisitions des clichés de diffraction, appelée image DHAADF. Ensuite, on réalise une comparaison DHAADF avec une banque de données d'images HAADF simulées avec des paramètres correspondant à l'acquisition des clichés de diffraction, par exemple la même défocalisation, le même angle de convergence, le même grossissement, la même température, etc. Le modèle atomistique choisi est celui qui donne le meilleur accord entre l'image de la banque de donnée et l'image DHAADF. Si l'image DHAADF ne correspond à aucun modèle connu, alors on peut procéder par itérations successives en rassemblant toutes les données connues sur l'échantillon, notamment les atomes utilisés pour la croissance du matériau. Ces données sont avantageusement croisées avec les connaissances en chimie et sur les matériaux, et avec toutes les autres mesures de caractérisation obtenues par exemple par spectrométrie de masse des ions secondaires ou (SIMS Secondary Ion Mass Spectrometry en terminologie anglo-saxonne), par analyse dispersive en énergie ou EDX (Energy Dispersive X-ray Spectrometry en terminologie anglo-saxonne) pour construire des modèles atomistiques les plus probables. Ces techniques sont bien connues de l'homme du métier en simulation atomistique. Ensuite on relaxe le système par exemple en utilisant des méthodes ab-initio, ou par des méthodes de type Monte-Carlo ou dynamique moléculaire, afin de trouver les positions des atomes énergétiquement les plus probables. Ensuite on calcule les images HAADF pour chaque modèle hypothétique, et le modèle atomistique retenu est celui qui donne l'image HAADF simulée la plus proche de DHAADF. Le contraste de l'image DHAADF est proportionnel au numéro atomique moyen, plus le contraste est élevé, plus l'atome à choisir pour le modèle aura un numéro atomique élevé. Cette image permet alors de positionner les atomes en fonction du contraste. Si le contraste est homogène, alors la composition chimique est homogène. S'il y a des variations dans le contraste, cela révèle la présence d'un autre type d'atomes. La valeur numérique du contraste donne une indication sur le numéro atomique moyen à positionner dans le modèle atomistique. Une simple projection du modèle sur l'image DHAADF donne une première idée de l'accord entre le modèle et l'expérience, une simulation précise peut être réalisée.

La méthode d'imagerie selon l'invention va être décrite plus particulièrement pour imager l'hydrogène sur le graphène.

Dans l'exemple décrit, les détecteurs choisis sont des détecteurs annulaires d'acceptance angulaire comprise dans l'intervalle angulaire [(n-1)×10, nxl0], en milliradians, avec n un entier positif n ≥ 1.

Le choix du type de détecteur élémentaire à utiliser peut se faire de la manière suivante.

Par exemple on commence par choisir des détecteurs annulaires, qui sont simples à utiliser d'un point de vue logiciel, et qui permettent de couvrir toute la gamme de signaux acquis expérimentalement, puis on ajuste la géométrie en fonction des besoins et des résultats, par exemple on peut construire un détecteur centré sur un pic de diffraction avec un bord graduel pour conserver sélectivement l'information de ce pic.

La forme des détecteurs élémentaires est choisie de sorte à être incluse dans le détecteur physique utilisé pour l'acquisition des données.

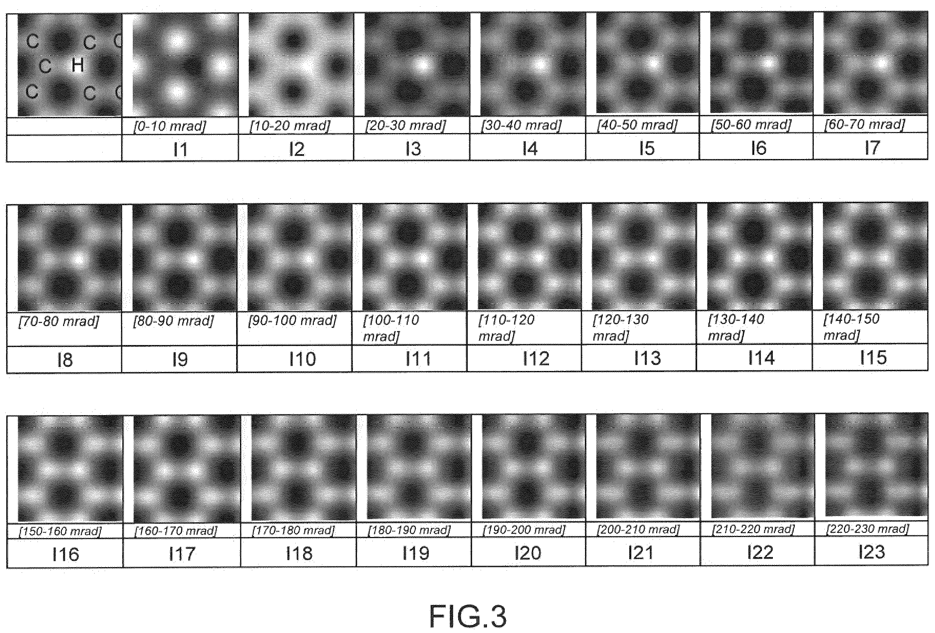

Sur la figure 3, on peut voir les images I1 à I23 obtenues avec les détecteurs annulaires. Les détecteurs sont désignés par la valeur de n définissant leur intervalle d'acceptance angulaire, par exemple le détecteur D1 a une acceptance angulaire entre 0 et 10 milliradians. Le détecteur D1 collecte les électrons diffractés dans un volume de collection défini entre un cône correspondant à un demi-angle au sommet de 5 mrad et un cône de demi-angle au sommet de 10 mrad.

Dans cet exemple, on considère 23 détecteurs entre 0 mrad et 230 mrad.

Les détecteurs considérés sont des détecteurs virtuels et sont désignés par détecteurs élémentaires.

Les images I1 à I23 sont calculées en prenant en compte le modèle atomistique de la figure 2, les paramètres du microscope et les paramètres des détecteurs virtuels élémentaires, qui sont dans l'exemple décrit des détecteurs annulaires. Les images résultent de l'interaction des électrons du microscope avec les atomes de l'échantillon.

Les images sont calculées pour le modèle atomistique de la figure 2, avec les conditions d'acquisition des images de diffraction suivantes : un angle de convergence du faisceau de 20 mrad, des électrons incidents de 80 keV, un coefficient d'aberration sphérique de 0,001 mm, une dispersion en énergie de 0,16 eV, un focus de - 2,5 nm (défocalisation de Scherzer) sans défaut d'astigmatisme, avec le logiciel QSTEM développé par l'Université d'HUmbold de Berlin https://www.physics.hu-berlin.de/en/sem/software/software qstem.

L'étape de calcul des images est une étape de simulation pour chaque détecteur élémentaire des images à partir des modèles atomistiques. Cette étape de simulation utilise les paramètres expérimentaux utilisés dans l'acquisition de données des clichés de diffraction, tels que la focalisation (defocus) l'angle de convergence utilisé, le courant, la durée d'intégration du signal, cette intégration ayant pour effet de sommer l'ensemble des signaux sur la durée d'acquisition, la température. La valeur de tout ou partie des paramètres sont déterminés en analysant les données des clichés de diffraction.

La méthode comprend ensuite la sélection des images parmi les images obtenues.

On constate que la visibilité de l'hydrogène n'est pas la même d'un détecteur à l'autre. Par exemple l'image calculée à partir du détecteur D3 offre beaucoup plus de contraste au voisinage de l'hydrogène que l'image calculée à partir du détecteur D16. On constate également que l'image calculée à partir du détecteur D2 présente une inversion de contraste par rapport celle calculé à partir du détecteur D1. En effet la fonction de transfert de contraste peut présenter des valeurs soit positives, soit négatives dans ces conditions expérimentales particulières.

Cette sélection est par exemple faite manuellement par l'opérateur ou de manière automatisée par un logiciel.

De plus, il est connu que pour détecter des éléments légers, le contraste de phase est à privilégier par rapport au contraste de numéro atomique, on cherche donc à prendre en compte préférentiellement les réponses dans la gamme [0 nm ; 100 nm] par rapport aux réponses dans la gamme [100 nm ; 300 nm].

De manière avantageuse, on soustrait à chaque image avec l'hydrogène I1 à I23 des détecteurs D1 à D23 respectivement une image obtenue pour un modèle atomistique sans hydrogène, i.e. une image de graphène seul. Les images sont désignées G1 à G23. Les images G1 à G23 sont calculées en considérant qu'elles seraient obtenues par les détecteurs D1 à D23.

Les images G1 à G23 sont obtenues par calcul à partir de clichés de diffraction acquis avec les détecteurs D1 à D23 pour un modèle atomistique d'échantillon sans hydrogène.

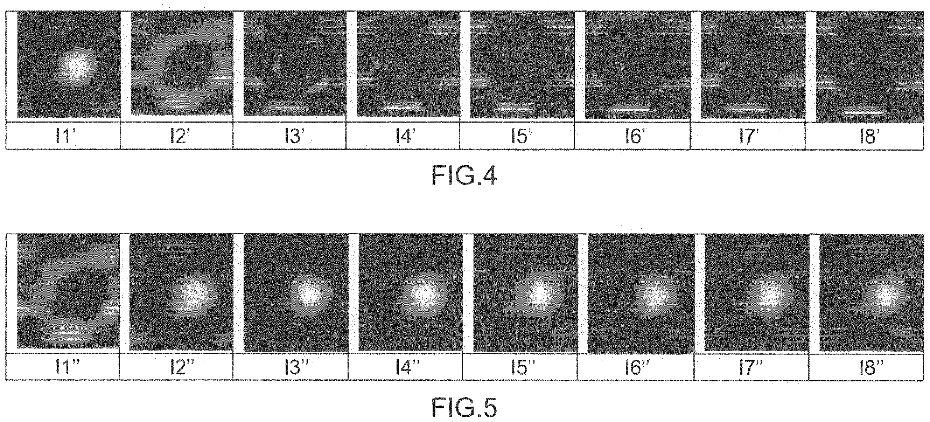

Sur la figure 4, on peut voir les images I1" à I8" obtenues par la soustraction des images G1 à G8 aux images I1 à I8. Il sera compris que les soustractions sont calculées pour les 23 images.

Sur la figure 5, on peut voir les images I1" à I8" obtenues par la soustraction des images I1 à I8 aux images G1 à G8 respectivement. Il sera compris que les soustractions sont calculées pour les 23 images. Le contraste noir est obtenu pour un niveau de gris inférieur ou égal à zéro.

Ensuite on utilise les images présentant un hydrogène suffisamment contrasté, i.e. une image présente un rapport signal/bruit suffisant au voisinage de la localisation de l'hydrogène.

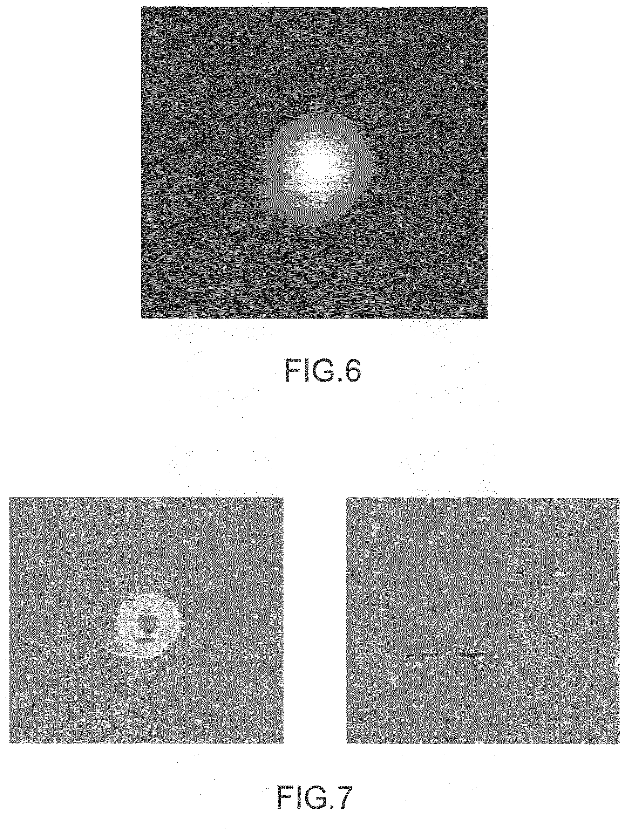

On constate que l'image I1'et les images I2" à I8 " présentent un contraste bien marqué au voisinage de l'hydrogène. En combinant ces images, on obtient une très bonne détection de l'hydrogène. On obtient alors l'image de la figure 6. Par exemple l'image de la figure 6 est obtenue en sommant puis en normalisant les valeurs absolues des contrastes pour que les minima et maxima des couleurs occupent toute la plage de visibilité de l'écran sans phénomène de saturation.

Dans la présente demande, on entend par « combiner les images », le fait d'appliquer aux images des opérations mathématiques plus ou moins complexes. Il peut s'agir de sommer les images comme dans l'exemple ci-dessus. En variante, la combinaison des images prévoit de pondérer la contribution de chaque image calculée à partir d'un détecteur élémentaire, dans ce cas l'opération mathématique est une multiplication de chaque signal émis par un détecteur élémentaire par un coefficient pondérateur. En variante, les opérations mathématiques peuvent consister à multiplier entre elles les réponses des détecteurs élémentaires pour obtenir plus de signal. En variante encore, les signaux sont exacerbés avec des fonctions puissance ou exponentielle.

La méthode selon l'invention présente l'avantage d'utiliser des signaux qui ne sont pas utilisés dans les méthodes de l'état de la technique. En effet les méthodes de l'état de la technique ne détectent que les électrons, alors que la méthode selon l'invention prend en compte les valeurs absolues des contrastes, ce qui revient à ajouter ou à soustraire localement le signal physique produit par les électrons.

L'image de la figure 6 serait celle obtenue avec un détecteur dont la réponse radiale est négative entre 0 mrad et 10 mrad et est positive entre 10 et 80 mrad, car l'image I1' est la soustraction de l'image G1 à l'image I1, alors que les images I2" à I8" sont les soustractions des images I2 à I8 aux images G2 à G8 respectivement.

L'image finale de la figure 6 comporte un maximum centré sur l'hydrogène avec un contraste supérieur à chaque image élémentaire, donc le rapport signal/bruit est nettement amélioré par rapport aux techniques usuelles. La combinaison d'images déterminée grâce à l'invention donne un résultat très largement supérieur aux techniques existantes qui ne prennent pas en compte les inversions de contrastes.

On a donc déterminé un détecteur optimisé pour cartographier l'hydrogène sur le graphène dans les conditions d'acquisition définis ci-dessus, i.e. un faisceau ayant angle de convergence de 20 mrad, des électrons incidents ayant une énergie de 80 keV, un coefficient d'aberration sphérique de 0,001 mm, une dispersion en énergie de 0,16 eV, une défocalisation de -2,5 nm (Scherzer), sans défaut d'astigmatisme.

Ce détecteur virtuel peut être enregistré et réutilisé directement pour cartographier l'hydrogène dans du graphène dans un autre échantillon, à partir de clichés de diffraction obtenus dans les mêmes conditions expérimentales, i.e. avec les mêmes réglages du microscope. Les clichés de diffraction pourront alors être directement traités en considérant un détecteur dont la réponse radiale est négative entre 0 mrad et 10 mrad et est positive entre 10 mrad et 80 mrad.

Dans cet exemple, les détecteurs annulaires ont tous une acceptance angulaire de 10°, cependant la prise en considération de détecteurs annulaires ayant des acceptances angulaires différentes les unes des autres ne sort pas du cadre de la présente invention. Plus le pas des détecteurs annulaire est fin, plus la quantité de calculs pour couvrir toute la gamme est grande. En outre comme nous le verrons par la suite, des détecteurs de types différents peuvent être pris en compte.

A titre de comparaison on a représenté sur la figure 7, à gauche, l'image obtenue par le détecteur virtuel optimisé tel que décrit précédemment, entre 0 mrad et 120 mrad, et une image $D_{HAADF}$ obtenue en utilisant les images des détecteurs D13 à D25 de la figure 3 (entre les angles 120 mrad et 250 mrad) Le calcul de l'image $D_{HAADF}$ correspond à l'image qui serait obtenue par la méthode HAADF (high-angle annular dark-field imaging en terminologie anglo-saxonne) ou méthode d'imagerie en champ sombre en grand angle. On constante que l'image $D_{HAADF}$ ne montre pas l'hydrogène. En fait les images D13 à D25 ne montrent pas l'hydrogène de manière assez contrastée. Le détecteur permettant d'obtenir l'image $D_{HAADF}$ est un détecteur HAADF mis en œuvre dans la méthode HAADF-HRSTEM qui est une imagerie de contraste atomique, car le contraste est proportionnel à une puissance comprise entre 1,6 et 2 du numéro atomique. Ce détecteur ne peut donc pas imager les éléments légers tels que l'hydrogène.

Dans l'exemple décrit ci-dessus, on souhaitait uniquement cartographier l'hydrogène sur le graphène. Mais la méthode selon l'invention permet de réaliser une cartographie de plusieurs éléments chimiques en utilisant les mêmes clichés de diffraction. En effet, la méthode applique un modèle atomistique adapté à chaque élément chimique à cartographier. On obtient alors autant d'images que d'éléments chimiques à cartographier, images qui peuvent être combinées de manière spécifique à chaque élément chimique.

La méthode selon l'invention permet également de détecter les lacunes et les nanopores enterrés, par exemple avec un modèle atomistique classiquement obtenu par des méthodes de simulation *ab-initio.*

La méthode élabore un détecteur virtuel pour chaque élément à cartographier.

L'élaboration de détecteurs sélectifs à un élément tout en restant aveugles à un autre élément est rendu possible grâce aux plages d'hypersensibilité et d'insensibilité. Pour chaque matériau et chaque élément, on examine les plages de sensibilité afin de construire sur la base de simulations un détecteur qui soit à la fois hypersensible à l'élément choisi et aveugle à l'autre élément.

Par conséquent avec une acquisition physique de clichés de diffraction avec un seul détecteur, une cartographie complète de l'échantillon peut être réalisée pour tous les éléments chimiques de la classification périodique. La méthode est alors relativement rapide. En outre, cela présente l'avantage de ne pas devoir soumettre l'échantillon au faisceau d'électrons plusieurs fois, ce qui réduit les risques d'endommagement de celui-ci.

Dans l'exemple décrit ci-dessus, les figures de diffraction sont acquises au moyen d'une technique d'imagerie électronique en transmission. En variante, les figures de diffraction peuvent être acquises au moyen d'une technique d'imagerie par réflexion, par exemple par microscopie électronique à balayage (SEM). On peut également utiliser des détecteurs des électrons de haute énergie en incidence rasante diffractés ou détecteur RHEED (Reflection High Energy Electron diffraction en terminologie anglo-saxonne) ou un détecteur d'électrons diffractés de faible énergie ou détecteur LEED (Low Energy Electron Diffraction en terminologie anglo-saxonne) disposés en amont de l'échantillon.

L'acquisition de donnée par une technique d'acquisition en réflexion permet d'imager la surface de l'échantillon.

La méthode d'imagerie selon l'invention permet d'imager tous les éléments de la classification périodique, ainsi que les lacunes. En outre elle permet d'augmenter la sensibilité à tous les éléments chimiques, même les éléments lourds. On constate qu'en appliquant la méthode d'imagerie à un élément lourd, la collecte du contraste par rapport aux techniques usuelles est augmentée significativement, typiquement le gain est supérieur à 20%.

En outre, la méthode selon l'invention collecte tout le contraste disponible, afin d'augmenter le rapport signal/bruit, même en cas d'inversions de contraste. La méthode selon l'invention exploite au maximum tout le signal collecté par le traitement numérique des données et la simulation atomistique. Tous les contrastes utiles sont donc avantageusement utilisés pour générer l'image sélective de l'élément choisi, notamment les éléments difficiles à imager, tels que l'hydrogène, les lacunes neutres, et les lacunes chargées.

En outre, la méthode d'imagerie offre une meilleure résolution spatiale, par exemple elle peut atteindre 63 pm avec une acquisition de clichés de diffraction par la méthode ISTEM avec un microscope Titan 80/300 GI, qui est normalement limité à une résolution de 83 pm. La méthode selon l'invention peut donc offrir un gain en résolution, avec une sensibilité chimique exacerbée et sélective.

En outre, on peut accéder à une sélectivité en profondeur des éléments en travaillant sur les réglages de l'acquisition des clichés de diffraction, et notamment l'angle de convergence et la focalisation. La grande résolution spatiale permet également d'envisager la cartographier des déformations mécaniques avec une excellente résolution, avec une seule et même acquisition de données rapide.

La méthode de cartographie selon l'invention présente l'avantage de s'adapter à chaque configuration, puisqu'elle permet d'élaborer le ou les images en prenant en compte les différents paramètres pouvant influencer la visibilité de l'élément. Dans l'exemple décrit ci-dessus, l'élément chimique, le matériau de l'échantillon, l'énergie du faisceau, des réglages du microscope ont été intégrés au processus de calcul théorique de l'image.

Il sera compris que tout paramètre pouvant influencer la visibilité de l'élément peut être intégré au processus de cartographie, tel que l'épaisseur de l'échantillon, la nanostructure de l'échantillon, de l'orientation de l'échantillon.

La méthode selon l'invention permet de construire numériquement des détecteurs virtuels optimisés particuliers à chaque cas de figure, ce qui offre beaucoup plus de flexibilité qu'un détecteur physique rigide, qui est généralement un compromis pour répondre aux contraintes technologiques en répondant pour le mieux aux besoins.

La méthode d'imagerie prévoit le choix d'une pluralité de détecteurs élémentaires pour le calcul des images avec le modèle atomistique. Les détecteurs peuvent avoir toute forme qui sera choisie en fonction de l'élément à cartographier. Par exemple, les détecteurs élémentaires peuvent être en forme de tronçons d'anneau, de disques, d'ellipse, de carré, d'un ensemble de pixels carrés, d'un ensemble de pixels rectangulaires, d'un ensemble de pixels hexagonaux, d'un ensemble de pixels polyédriques ou toute forme qui s'avère avantageuse à l'issue de simulations atomistiques. Par exemple l'intersection d'ellipses est particulièrement avantageuse car elle permet la sélectivité cristalline. En effet, en utilisant un filtre à trous elliptiques, il est possible de sélectionner dans le réseau réciproque les pics de diffractions attendus pour la phase choisis. De préférence, la périphérie des trous elliptique présente une frontière graduelle, par exemple un flou gaussien, pour minimiser les artéfacts éventuels lors de la transformation numérique de l'espace réel à l'espace réciproque. En choisissant ce type de détecteur ou filtre, on ne conserve que l'information spécifiquement liée à la phase cristalline choisie, de manière sélective. Inversement, on peut également choisir d'éliminer tous les spots de diffraction correspondant à une phase cristalline en appliquant un filtre avec des spots noirs elliptiques à bords graduels à l'emplacement des pics attendus, afin d'éliminer sélectivement toute information relative à cette phase avant la transformation en image depuis le réseau réciproque vers le réseau réel. De cette manière, on obtient un détecteur virtuel sélectif à la phase cristalline. C'est le modèle atomistique qui permet de prédire la localisation précise des pics de diffraction attendus dans le réseau réciproque.

Le type de détecteur peut également être choisi pour limiter l'influence de certains paramètres sur les images. Par exemple on peut avantageusement choisir un type de détecteur qui permet de limiter, voire annuler, l'influence de l'épaisseur de la lame sur les images et les contrastes. Selon une variante du procédé de cartographie, on choisit les détecteurs élémentaires qui sont peu affectés par les fluctuations d'épaisseur, ce qui permet d'élaborer un détecteur virtuel très stable sur une large plage d'épaisseurs. Pour réaliser ce détecteur, on réitère les simulations en faisant varier l'épaisseur de l'échantillon et de sélectionner uniquement les combinaisons de détecteurs qui restent efficaces dans toutes la plage d'épaisseurs.

Selon une variante avantageuse, la méthode selon l'invention permet de s'affranchir des fluctuations locales de l'épaisseur de l'échantillon qui est susceptible d'engendrer des artefacts. Pour cela, la méthode de cartographie prend comme référence l'image obtenue avec un détecteur aveugle à l'élément à cartographier, par exemple tel que l'image $D_{HAADF}$ dans le cas particulier de la figure 7. Cette image de référence est soustraite de l'image obtenue avec le détecteur virtuel hypersensible pour s'affranchir des effets des fluctuations spatiales d'épaisseurs ou autres artéfacts indésirables tels que les effets d'amorphisation lors de la préparation d'échantillons.

On peut également envisager d'élargir le champ d'analyse afin de couvrir une surface beaucoup plus large et de minimiser le débit de dose d'électrons appliqué à l'échantillon. Le détecteur virtuel est alors élaboré avec une forme spécifique de détecteur grand champ. Néanmoins ce gain en surface s'effectue généralement aux dépens de la résolution spatiale.

La méthode de cartographie peut prévoir également d'appliquer des conditions particulières lors de l'acquisition des clichés de diffraction, soit par exemple pour améliorer la détectivité, la sensibilité, soit par exemple pour obtenir d'autres informations.

Selon un premier exemple, la lame d'échantillon est orientée de manière contrôlée et le détecteur virtuel est conçu en tenant compte de cette orientation. Le choix d'une orientation peut permettre des lever certaines ambiguïtés en apportant une dimension supplémentaire à l'espace des observables.

Selon un autre exemple, on applique une polarisation à l'échantillon pendant l'acquisition des clichés de diffraction, ce qui peut permette de gagner en détectivité et sensibilité, notamment sur les espèces chargées.

Il est par exemple possible de repousser des espèces chargées positivement en polarisant positivement l'échantillon. L'application de cette polarisation électrique est prise en compte dans le modèle atomistique et donc dans les propriétés des détecteurs élémentaires. La comparaison entre la mesure sans polarisation et la deuxième mesure avec polarisation permet d'obtenir des informations avec une sensibilité exacerbée par comparaison soustractive.

L'application d'une polarisation peut permettre de cartographier les contaminants chargés à la surface de l'échantillon.

En variante la polarisation de l'échantillon est réalisée entre le calcul de deux images. On réalise une première image en appliquant la méthode selon l'invention, puis on applique une polarisation qui a pour effet d'éjecter les contaminants, par exemple les anions Cl-, et on calcule une nouvelle image avec la méthode selon l'invention qui peut être comparée à l'image obtenue avant et après polarisation. Ces simulations permettent d'interpréter les différences potentielles entre les mesures réalisées avec et sans polarisation électrique.

En variante, l'application d'une polarisation peut permettre de cartographier les lacunes chargées positivement, par exemple en les faisant remonter à la surface ou en les faisant complètement disparaitre en appliquant un champ électrique qui les force à se recombiner avec les couches superficielles oxydées.

Dans un autre exemple on prévoit, lors de l'acquisition des clichés de diffraction, de polariser le faisceau d'électron, en figeant l'orientation du champ électrique de l'onde électromagnétique générée par le faisceau d'électrons. Ces mesures permettent d'envisager la cartographie sélective des moments magnétiques des sous-espèces présentes dans l'échantillon.

Dans un autre exemple, l'acquisition des clichés de diffraction est réalisée plaçant le microscope en mode précession, i.e. en inclinant le faisceau d'électrons par rapport à la direction principale et en le mettant en rotation de sorte qu'il balaie une surface conique, le faisceau incident est alors un cône de précession, ce qui permet d'obtenir les avantages de la diffraction par précession, c'est-à-dire l'acquisition de diagrammes de diffraction quasi-cinématiques, une plus grande extension des réflexions, une plus grande robustesse des mesures et une petite taille de sonde. Ce mode d'acquisition est pris en compte dans le choix des détecteurs élémentaires.

Dans un autre exemple, on utilise un faisceau parallèle, i.e. dont l'angle de convergence est nul, lors de l'acquisition des clichés de diffraction. Les spots de diffraction des clichés sont alors plus fins, ce qui permet notamment des mesures résolues en moment angulaire. De manière avantageuse, le détecteur virtuel est alors élaboré de sorte à être centré sur un spot de diffraction pour sélectionner la direction du moment angulaire.

Selon un autre exemple, on applique un coefficient d'aberration sphérique négatif pour modifier la fonction de transfert de contraste, ce qui permet de modifier de manière contrôlée la fonction de transfert de contraste afin d'augmenter les possibilités de réalisation de détecteur virtuel optimisé ajusté sur la fonction de transfert de contraste. Avec un tel coefficient d'aberration on augmente le nombre d'électrons élastiques collectés.

Selon un autre exemple, on modifie la défocalisation lors de l'acquisition de clichés de diffraction pour rechercher des espèces enterrées sous la surface de l'échantillon. A chaque défocalisation, une nouvelle acquisition de clichés de diffraction est réalisée. L'élaboration du détecteur virtuel tient compte de la défocalisation, qui peut aider à améliorer la sélectivité de profondeur, par exemple pour réaliser une cartographie résolue en profondeur. Dans cet exemple, les simulations sont réitérées pour chaque valeur de défocalisation expérimentale, afin d'optimiser la construction des détecteurs virtuels sut toute la plage de défocalisation.

Selon d'autres exemples, des conditions particulières sont appliquées à l'échantillon pour collecter des informations supplémentaires.

Selon un exemple, on fait circuler un courant dans l'échantillon lors de l'acquisition de clichés. Pour ce faire, on peut réaliser un dispositif fonctionnel avec une géométrie dédiée en forme de lame TEM. En couplant le balayage du faisceau d'électrons avec un test électrique in-situ on peut obtenir des informations sur les propriétés électriques de la zone irradiée par les électrons. L'échantillon est modifié électriquement, et on peut élaborer les détecteurs virtuels en tenant compte de ces conditions particulières d'acquisition. En effet, la polarisation électrique modifie le contraste des images, et les phénomènes de piégeage de charge ou de décharge électrostatique, par exemple sur les lacunes chargées, peuvent activer localement des contrastes visibles en microscopie électronique.

En variante de la circulation d'un courant dans l'échantillon, on peut réaliser les mesures électriques in-situ en appliquant des impulsions en tension ou en courant synchronisées avec le balayage du faisceau d'électrons lors de la mesure. De cette manière on peut activer ou désactiver sélectivement des espèces, par exemple les lacunes chargées, afin de les rendre plus visibles en microscopie électronique, uniquement lors du passage du faisceau d'électrons.

Selon un autre exemple, on prévoit d'injecter un gaz lors des mesures pour étudier la réactivité chimique de l'échantillon. Le détecteur virtuel est donc adapté à cet environnement réactionnel spécifique. Par exemple, en injectant du chlore lors de l'acquisition des données et en intégrant cette donnée lors de l'élaboration du détecteur virtuel, on peut réaliser un détecteur hypersensible au chlore.

Selon un autre exemple encore, on modifie la température. Par exemple on réalise une acquisition à basse température et une acquisition à plus haute température et en comparant les deux images obtenues par la méthode selon l'invention. A basse température, les espèces les plus fragiles, comme l'hydrogène ou les lacunes, sont figées et immobilisées. On peut obtenir des images de qualité améliorée. A plus haute température, les espèces se désorbent progressivement, et la comparaison des mesures à basse température et haute température permet par différence de mettre en évidence les effets des espèces qui ont disparu.

Dans un autre exemple, on prévoit de contrôler la pression afin d'observer les différences structurales issues de la pression.

La méthode de cartographie selon l'invention peut également permettre de cartographier d'autres propriétés physiques de l'échantillon, par exemple de cartographier spatialement les champs électriques et/ou les champs magnétiques, simultanément à la réalisation de la cartographie de la ou des espèces, et avec une acquisition de clichés de diffraction incluse dans celle utilisée dans la présente invention pour mettre au point le détecteur virtuel. La méthode peut par exemple permettre de réaliser des détecteurs virtuels segmentés en plusieurs quadrants. Les détecteurs segmentés à plusieurs quadrants réels sont bien connus de l'homme du métier pour cartographier les champs électriques et/ou magnétiques. La technique mettant en œuvre des détecteurs segmentés à plusieurs quadrants réels est décrite dans le document J.N. Chapman, P.E.Batson, E.M.Waddell, R.P.Ferrier, Direct determination of magnetic domainwall profiles by differential phase-contrast electron-microscopy, Ultramicroscopy 3, 1978, 203 to 214.

Selon un autre exemple, la méthode prévoit d'utiliser un détecteur virtuel décentré par rapport à l'axe du faisceau dans l'espace réciproque, par exemple pour simuler des mesures résolues en moment angulaire, ce qui permet de cartographier les propriétés piézoélectriques et ferroélectriques des échantillons. Il peut même être envisagé d'accéder à des informations plus fines telles que l'état de charge des lacunes par exemple. C'est la simulation atomistique qui permet de déterminer l'influence de l'état de charge sur les propriétés résolues en moment angulaire dans chaque cas particulier.

La méthode selon l'invention permet d'élaborer tout type de détecteur virtuel et offre donc une large gamme d'analyse de l'échantillon pour obtenir des informations variées sur celui-ci, de manière rapide et sans nécessiter la mise en place de détecteur réel dédié. En outre, puisque ce sont les mêmes données (clichés de diffraction) qui servent à la fois à cartographier la ou les espèces chimiques et d'autres propriétés de l'échantillon, les cartographies réalisées sont obtenues sur le même échantillon dans exactement les mêmes conditions, en une seule acquisition.

Des conditions particulières peuvent être intégrées aux détecteurs lors de leur élaboration de sorte, par exemple à filtrer certains signaux. Par exemple des traitements numériques sont effectuer pour réduire, voire supprimer, le bruit, par exemple en effectuant une transformée de Fourier, un filtre passe-bande, puis une transformée de Fourier inverse (apodisation). Ce filtre est intégré lors de l'élaboration des détecteurs élémentaires et/ou lors l'assemblage numérique, des détecteurs élémentaires en vue de réaliser le détecteur virtuel. D'autres procédés de filtrages sont intégrables aux détecteurs élémentaires, par exemple pour éliminer le fond continu lié à la présence d'amorphisation ou le signal parasite provenant de différentes sources de bruit.

En variante, on peut adapter le détecteur virtuel pour générer du contraste de phase. Des traitements numériques sélectifs sont réalisés sur les parties réelles ou imaginaires des fonctions d'ondes. De manière avantageuse, on utilise les symétries particulières des fonctions d'onde pour réaliser des traitements de données plus efficaces. Les images de contraste de phase présentent l'avantage d'être particulièrement contrastées au niveau des zones endommagées, par exemple les zones endommagées par la préparation d'échantillons. C'est l'obtention des images de contraste de phase à l'issue d'une reconstruction (par exemple ptycographique) dans le réseau réel qui permet d'effectuer ce type de traitements.

Selon un autre exemple, on peut effectuer un filtrage directement sur les données fournies par les clichés de diffraction, i.e. avant le calcul des images à partir des détecteurs élémentaires. Ce filtrage peut par exemple consister à ne sélectionner qu'une fraction des électrons diffusés, par exemple il peut consister à ne conserver que les électrons inélastiques ayant perdu une certaine quantité d'énergie à l'issue d'une interaction avec les atomes de l'échantillon. Dans le cas de la cartographie de l'hydrogène, le filtrage peut consister à ne sélectionner que la fraction des électrons ayant subi une perte d'énergie représentative du pic plasmon de l'hydrogène (13.6 eV), on obtient alors uniquement les électrons ayant subi un choc inélastique avec l'hydrogène de l'échantillon. L'atlas EELS (electron energy loss spectroscopy à ou de spectroscopie en perte d'énergie), donne les énergies représentatives de chaque espèce chimique, par exemple 21.2 eV pour l'hélium. Ce filtrage de données supplémentaire permet donc d'obtenir une sélectivité additionnelle, par exemple en ne conservant que les électrons ayant subi une perte d'énergie voisine de 21,2 eV, on obtient les électrons ayant interagi inélastiquement avec les atomes d'hélium.

La méthode de cartographie selon l'invention peut avantageusement être mise ne œuvre pour déterminer la contribution d'une espèce. Par exemple, on réalise une première image de référence d'un échantillon avec la méthode selon l'invention, puis on applique un traitement l'échantillon, par exemple pour modifier une espèce chimique, et on réalise une nouvelle image par la méthode selon l'invention et par comparaison pour peut déterminer la contribution de cette espèce chimique. Par exemple, on réalise un image de référence d'un échantillon avec des lacunes d'oxygène, puis on applique un traitement à l'échantillon, qui a pour effet d'annihiler les lacunes d'oxygène, par exemple un plasma d'ozone, puis on réalise une nouvelle image. La comparaison des deux images permet de mettre en relief la contribution des lacunes d'oxygène.

La méthode selon l'invention permet d'élaborer un détecteur virtuel avec des caractéristiques très spécifiques qui n'ont éventuellement jamais été combinées dans un détecteur réel et/ou qui ne pourraient pas être combinées dans un détecteur réel.

Par exemple, il peut être envisagé de construire des détecteurs élémentaires dans lequel le signal de chaque détecteur élémentaire est élevé à une puissance proportionnelle à la quantité d'électrons obtenue par la simulation. Le détecteur virtuel n'est alors pas une combinaison linéaire de détecteurs élémentaires, mais une somme ou un produit de détecteurs élémentaires à avalanche, qui présentent un gain interne. Le détecteur virtuel a un comportement équivalent à celui des photodiodes à avalanches.

Il sera compris que certains des exemples sont combinables, par exemple la méthode d'imagerie peut prévoir d'appliquer une ou des conditions lors de l'acquisition des données et d'intégrer un filtre aux détecteurs virtuels.

La méthode d'imagerie selon l'invention présente en outre l'avantage de pouvoir être facilement automatisée, afin de traiter massivement et rapidement une grande quantité de données expérimentales, typiquement des térabytes de données. A partir d'une acquisition par exemple 4D-STEM ou ISTEM rapide, le calcul des images par la méthode selon l'invention pour l'hydrogène, les lacunes, et tout ou partie des éléments de la classification périodique peut être réalisé rapidement. Ces images peuvent aider à optimiser les réglages du microscope, car les détecteurs virtuels obtenus par la méthode selon l'invention peuvent générer des images particulièrement ciblées sur des détails très visibles, par exemple la présence de pics liés à des réflexions cristallines lointaines. Par exemple, dans le cas du silicium à 200 kV, la présence de la raie [5-5-1] permet de vérifier que la résolution spatiale est meilleure que 76 pm. En centrant le détecteur virtuel sur cette raie, on peut vérifier que cette résolution spatiale est bien atteinte.

La méthode d'imagerie selon la présente invention peut être appliquée dans de nombreux domaines.

Par exemple, elle peut être utilisée dans le domaine des mémoires résistives. Les lacunes, notamment d'oxygène, jouent un rôle essentiel dans les mémoires résistives et il est très difficile, voire impossible de les cartographier. La méthode d'imagerie selon la présente invention permet de détecter de telles lacunes, par exemple en utilisant un dispositif (par exemple un point mémoire résistif RRAM) fonctionnel en forme de lame de microscopie électronique en transmission et en réalisant les mesures avec la méthode selon l'invention *in-situ* voire *in-operando.*

La méthode d'imagerie peut être également utilisée pour imager les interfaces CMOS. Les lacunes et l'hydrogène sont susceptibles d'impacter la performance électrique des interfaces, ce qui peut se traduire par exemple par la présence de courants de fuites résiduels, éventuellement activés par des phénomènes de charge/décharge de porteurs de charges piégés sur ces types de défauts. L'hydrogène à un rôle de passivation des liaisons pendantes, mais il est très labile donc susceptible de migrer et de diffuser assez facilement, surtout quand la température est élevée lors des procédés technologiques. La migration de l'hydrogène peut engendrer la création de lacunes, éventuellement chargées, qui sont des défauts électriquement actifs susceptibles d'engendrer des chemins de conduction électriques. Ces sources de fuite de courant assistées par pièges peuvent conduire au claquage diélectrique destructif. La cartographie de l'hydrogène et des lacunes qui peut être obtenues grâce à la méthode selon l'invention formera un outil critique d'analyse de performances et de fiabilité des dispositifs CMOS et dérivés.

La méthode d'imagerie peut être également utilisée pour l'étude des gravures en microélectronique. Les générations avancées de gravure utilisent parfois des plasmas hydrogénés pour minimiser l'endommagement, et il est important d'analyser les conséquences de ce type de procédé en termes de défectivité et de profondeur d'implantation d'hydrogène. La création de lacunes est également un mécanisme potentiel d'endommagement lié aux gravures plasma, par conséquent la mesure des profils de concentration d'hydrogène et de lacunes est un outil essentiel pour cartographier la défectivité des flancs de gravure qui peut s'avérer critique pour les performances et la fiabilité du dispositif. Il est possible que les défauts de gravure génèrent des chemins de conduction électrique parasite le long des flancs, ce qui risque de compromettre la durée de vie à long terme des dispositifs. La méthode d'imagerie selon l'invention peut permettre d'analyser précisément et modéliser la défectivité des flancs de gravure.

La méthode d'imagerie peut être également utilisée pour l'analyse de l'impact des plasmas d'hydrogène pour la préparation d'échantillons. La préparation d'échantillons requiert une finition par un plasma d'hydrogène susceptible d'interagir voire d'endommager l'échantillon. Dans le meilleur des cas, le plasma a pour fonction principale de passiver les liaisons pendantes de surface, mais pour les échantillons les plus sensibles il n'est pas exclu que l'hydrogène pénètre à l'intérieur de l'échantillon et le modifie, par exemple par l'intermédiaire de réactions de réduction électrochimique. L'hydrogène peut modifier la structure et éventuellement générer des défauts, similaire au phénomène de gonflement et fissuration des métaux soumis à des irradiations nucléaires.

La méthode d'imagerie peut être également utilisée pour analyser l'impact des procédés sur la formation des lacunes. Les lacunes se forment dans un grand nombre de réactions en phase solide, elles permettent de créer des chemins de diffusion atomiques, elles apparaissent par exemple en fond d'implantation, à l'issue de recuits, de gravures, d'épitaxies très contraintes, de procédés électrochimiques, et leur présence est essentielle pour expliquer de nombreux phénomènes physiques qui font intervenir des réorganisations de la matière à l'échelle subnanométrique.

La méthode d'imagerie peut être également utilisée pour analyser les défectivité des transistors à effet de champ à doigts ou FINFETS (Fin Field-effect transistors en terminologie anglo-saxonne). Les lacunes et autres défauts de structures sont susceptibles de se former à la périphérie des canaux de type FIN présents dans les FINFETS. La cartographie des lacunes et de l'hydrogène permet d'estimer la présence de ce type de défauts aux interfaces critiques, en lien avec la performance électrique et la fiabilité.

La méthode d'imagerie peut être également utilisée pour l'étude des substrats silicium sur isolant totalement déserté ou FDSOI (Fully depleted silicium on insulator en terminologie anglo-saxonne). Les lacunes et l'hydrogène jouent également un rôle important dans les filières de type FDSOI et dérivées, car elles font intervenir des interfaces entre un oxyde (généralement l'oxyde de silicium) et un matériau cristallin (généralement le silicium). Cette interface est susceptible de modifier la durée de vie des dispositifs car si des pièges électriquement actifs sont localisés à cet endroit, alors des phénomènes de décharge électrostatiques peuvent potentiellement modifier la dynamique des porteurs et le comportement en fréquence des dispositifs. Dans les cas les plus défavorables des courants de fuite peuvent se former assistés par la conduction par pièges et le dispositif peut éventuellement devenir défectueux en régime de fonctionnement. Par conséquent la cartographie des pièges lacunaires ou hydrogénés est un outil important d'analyse de performance et de fiabilité des dispositifs FDSOI avancés.

La méthode d'imagerie peut être également utilisée pour la caractérisation avancée de Qbits. Les lacunes et l'hydrogène sont susceptibles de modifier le comportement dynamique des Qbits, notamment à l'interface entre les canaux et les drains ou entre $SiO_2$ et HfSiON. La méthode de cartographie selon l'invention permet d'apporter des éléments d'interprétation susceptibles d'expliquer le comportement électrique de ce type de dispositif, afin d'améliorer les temps de cohérences de ce type de dispositifs.

La méthode d'imagerie peut être également utilisée pour analyser des transistors 2D, en particulier pour faire le lien entre nanostructure et performance électriques. Les lacunes sont également susceptibles de se rencontrer aux interfaces contraintes ou aux marches cristallines qui peuvent apparaitre lors de la croissance, et l'hydrogène est souvent utilisé pour nettoyer les surfaces, par exemple avec les nettoyages de type SHIRAKI qui se terminent par une passivation par des liaisons hydrogène. Il est donc important de savoir si l'hydrogène est partiellement incorporé à l'échantillon lors de la reprise de croissance ou s'il est complètement désorbé, car les propriétés électriques sont susceptibles d'être fortement impactées par la présence d'hydrogène.

La méthode d'imagerie peut être également utilisée pour l'analyse des mécanismes de production et de stockage d'hydrogène à l'échelle atomique. La problématique de stockage de l'hydrogène engendre des besoins de matériaux performants qui restent stables et répondent aux normes de sécurité drastique exigées par ce type de dispositif embarqué. Il est notamment important de caractériser les mécanismes de diffusion (souvent rapide) de l'hydrogène dans les matériaux, par exemple via des canaux de migration lacunaires.

La méthode d'imagerie peut être également utilisée pour l'analyse des phénomènes de vieillissement, des phénomènes d'électromigration des interconnexions. Les lacunes jouent un rôle critique dans les phénomènes d'électromigration, car elles précipitent la formation de voids (trous) dans les interconnexions, sous l'effet combiné du courant électrique, de la température et des gradients de contraintes. En général, il est très difficile de visualiser la migration des lacunes. La méthode selon l'invention pour permettre ce type de caractérisation, dans des mesures d'électromigration in-situ par exemple.

La méthode d'imagerie peut être également utilisée dans l'étude des interfaces critiques de transistors de puissance. Les lacunes et l'hydrogène peuvent jouer un rôle majeur dans les interfaces des transistors de puissance, qui sont soumises à des températures et des champs électriques particulièrement élevés (>200°C, >MV/cm) dans leur régime de fonctionnement. La méthode selon l'invention peut permettre d'étudier à l'échelle atomique des défauts lacunaires ou hydrogénés et donc aider à améliorer la réalisation de ce type de dispositifs particulièrement sensible aux effets d'interfaces, par exemple au voisinage du gaz bidimensionnel de porteurs de charges.

La méthode d'imagerie peut être également utilisée pour suivre la dégradation des échantillons sous faisceau à partir des évolutions temporelles des images obtenues par la méthode selon l'invention. Les cartographies de lacunes permettent de comprendre par exemple les phénomènes de dégradation sous faisceau susceptibles de survenir lors des mesures. On constate par exemple une évolution progressive des images par exemple de $SiO_2$ qui engendre la formation de tâches qui peuvent évoluer jusqu'à former de pores macroscopiques par agglomération de lacunes d'oxygène. La méthode selon l'invention permet donc de mieux visualiser, comprendre et contrôler la formation de pores dans l'échantillon par l'intermédiaire de la condensation de lacunes d'oxygène induite par le faisceau d'électrons.

La méthode d'imagerie peut être également utilisée pour l'étude de dispositifs optoélectroniques et les systèmes microélectromécaniques.

Dans les dispositifs optoélectroniques et les systèmes microélectromécaniques, les lacunes et l'hydrogène sont susceptibles de modifier par exemple la largeur de bande interdite, donc les propriétés électrooptiques. Les lacunes peuvent engendrer la présence de centres optiquement actifs visibles par exemple par photoluminescence ou électroluminescence, qui pourront être comparés avec les mesures faites par la méthode selon l'invention. Ce couplage des mesures peut permettre de valider un modèle atomistique interprétatif de l'ensemble des résultats.

La méthode d'imagerie peut être également utilisée pour la nanocaractérisation de dispositifs réalisés par le procédé SMARTCUT®. Le procédé SMARTCUT® implique la présence d'une couche riche en hydrogène et la présence de lacunes inhérents aux processus d'implantation ioniques. L'analyse de ce procédé nécessite donc de caractériser la présence d'hydrogène et la présence de lacunes, ces présences peuvent être caractérisées par la méthode selon l'invention.

La méthode d'imagerie peut être également utilisée pour la nanocaractérisation de filtres à gaz à base de membranes de graphène. Les membranes de graphène peuvent être percées de trous de dimensions subnanométriques afin de jouer le rôle de membrane de filtrage de gaz. En effet, la forme et la répartition des trous permet de contrôler précisément la perméation des gaz, par exemple des trous suffisamment petits permettent uniquement à l'hydrogène de passer. Il est donc possible de filtrer un mélange de gaz pour ne garder que l'hydrogène et éliminer par exemple les résidus de $H_2S$ susceptibles de se former lors de la synthèse.

La méthode d'imagerie peut être également utilisée pour la nanocaractérisation de membranes hyperélastiques à base de matériaux carbonés hydrogénés. Les matériaux de type membranaires à base de carbone et d'hydrogène peuvent présenter des propriétés élastiques très particulières en raison de la structuration très particulière de ce matériau hydrogéné. Sous l'effet des contraintes mécaniques, les liaisons peuvent se réarranger rapidement en faisant évoluer par exemple leurs proportions de liaisons sp2 et sp3, afin de conférer à la membrane une résistance et une élasticité exceptionnelle. La méthode d'imagerie permet d'étudier ce type de matériau à l'échelle picométrique.

## Revendications

1. Méthode d'imagerie d'au moins un élément donné dans un matériau donné d'un échantillon comportant :

    a) l'acquisition de clichés de diffraction d'une pluralité d'emplacements d'une zone donnée de l'échantillon par balayage au moyen d'un faisceau d'électrons ou de rayons X de la zone donnée,
    b) la détermination d'un modèle atomistique entre l'élément donné et le matériau donné, le modèle atomistique étant adapté à chaque élément chimique à cartographier,
    c) le choix d'une pluralité de détecteurs élémentaires en fonction du modèle atomistique, les détecteurs élémentaires étant des détecteurs numériques et non réels,
    d) le calcul, pour chaque détecteur élémentaire, des images théoriques, dans l'espace réel obtenues à partir du modèle atomistique avec élément et à partir du modèle atomistique sans élément pour un réglage physique instrumental donné et des données de clichés de diffraction acquises à l'étape a),
    e) le calcul pour chaque détecteur élémentaire de la différence entre les images dans l'espace réel obtenues à partir du modèle atomistique avec élément et du modèle atomistique sans élément, dites premières images,
    f) la sélection d'images parmi les premières images, sur lesquelles il existe un fort contraste au voisinage de l'élément donné,
    g) La combinaison des images sélectionnées pour former une deuxième image de l'élément donné dans le matériau donné.

2. Méthode d'imagerie selon la revendication 1, comportant à l'étape e), l'étape de calcul de troisièmes images résultant de la soustraction des images calculées à partir du modèle atomistique sans élément aux images calculées à partir du modèle atomistique avec élément, et le calcul de quatrièmes images résultant de la soustraction des images calculées à partir du modèle atomistique avec élément aux images calculées à partir du modèle atomistique sans élément, et dans lequel l'étape de sélection est une sélection parmi les troisièmes et quatrièmes images.

3. Méthode d'imagerie selon la revendication 1 ou 2, dans laquelle l'étape de combinaison combine les valeurs absolues des contrastes de toutes les images sélectionnées.

4. Méthode d'imagerie selon l'une des revendications précédentes, dans laquelle les détecteurs élémentaires choisis sont des détecteurs annulaires d'acceptance angulaire comprise entre nx10 mrd et $(n+1) \times 10$ mrd.

5. Méthode d'imagerie selon l'une des revendications précédentes, dans laquelle les étapes b) à g) sont répétées pour chaque élément de l'échantillon.

6. Méthode d'imagerie selon l'une des revendications précédentes, dans laquelle l'élément est un élément chimique du tableau périodique ou une lacune neutre ou une lacune chargée.

7. Méthode d'imagerie selon l'une des revendications précédentes, comportant l'étape de cartographie supplémentaire d'au moins une autre propriété physique de l'échantillon.

**8.** Méthode d'imagerie selon la revendication précédente, où l'étape de cartographie supplémentaire est une étape de cartographie des champs électrique et/ou des champs magnétiques dans l'échantillon, et dans laquelle un détecteur virtuel annulaire à quatre quadrants est déterminé numériquement.

**9.** Méthode d'imagerie selon l'une des revendications précédentes, comportant après l'étape d), le calcul d'une image à partir d'un détecteur aveugle à l'élément, et le calcul de la différence normalisée entre l'image obtenue à l'étape g) qui est hypersensible à l'élément et l'image aveugle à cet élément.

**10.** Méthode d'imagerie selon l'une des revendications précédentes, dans laquelle les détecteurs élémentaires sont choisis de sorte à être peu sensibles à l'épaisseur de l'échantillon, et/ou dans laquelle la méthode comporte l'intégration de filtres dans les détecteurs numériques élémentaires.

**11.** Méthode d'imagerie selon l'une des revendications précédentes, dans laquelle l'acquisition de l'étape a) est réalisée par microscopie électronique en transmission.

**12.** Méthode d'imagerie selon l'une des revendications précédentes, dans laquelle l'élément donné est l'hydrogène ou une lacune neutre ou une lacune chargée.

**13.** Méthode d'imagerie différentielle comportant :

- la formation d'une deuxième image par la mise en œuvre de la méthode selon l'une des revendications 1 à 12,
- l'application d'au moins une condition modifiant au moins ladite zone de l'échantillon,
- la formation d'une autre deuxième image de ladite zone par la mise en œuvre de la méthode selon l'une des revendications 1 à 12,
- l'analyse différentielle des deux deuxièmes images.

**14.** Méthode d'imagerie différentielle selon la revendication 13, dans laquelle la condition appliquée à l'échantillon est choisie parmi une polarisation électrique, un environnement gazeux et une température.

**15.** Méthode d'élaboration d'un détecteur d'imagerie d'un élément donné sur ou dans un matériau donné dans des conditions expérimentales données comportant les étapes :

a') l'acquisition de clichés de diffraction d'une pluralité d'emplacements d'une zone donnée de l'échantillon par balayage au moyen d'un faisceau d'électrons ou de rayons X de la zone donnée dans lesdites conditions expérimentales données,

b') la détermination d'un modèle atomistique entre l'élément chimique donné et le matériau donné, le modèle atomistique étant adapté à chaque élément chimique à cartographier,

c') le choix d'une pluralité de détecteurs élémentaires en fonction du modèle atomistique, les détecteurs élémentaires étant des détecteurs numériques et non réels,

d') le calcul de premières images de la zone donnée qui auraient été obtenues par la pluralité de détecteurs élémentaires choisis, à partir des clichés de diffraction et du modèle atomistique,

e') la sélection des détecteurs élémentaires ayant donnés par calcul les images parmi des images calculées issues des premières images, sur lesquelles il existe un fort contraste au voisinage de l'élément donné,

f') la combinaison des détecteurs élémentaires pour former un détecteur apte à imager l'élément donné dans le matériau donné.

**Patentansprüche**

**1.** Bildgebungsmethode mindestens eines gegebenen Elements in einem gegebenen Material einer Probe, aufweisend:

a) das Erfassen von Beugungsmustern einer Vielzahl von Stellen einer gegebenen Zone der Probe durch Elektronen- oder Röntgenstrahlabtastung der gegebenen Zone,

b) das Bestimmen eines atomistischen Modells zwischen dem gegebenen Element und dem gegebenen Material, wobei das atomistische Modell an jedes zu kartographierende chemische Element angepasst ist,

c) das Wählen einer Vielzahl elementarer Detektoren in Abhängigkeit vom atomistischen Modell, wobei die elementaren Detektoren digitale und nicht reale Detektoren sind,

d) das Berechnen, für jeden elementaren Detektor, der theoretischen Bilder im realen Raum, die ausgehend vom atomistischen Modell mit Element und ausgehend vom atomistischen Modell ohne Element für eine gegebene instrumentelle physikalische Einstellung erhalten werden und der Daten der in Schritt a) erfassten Beugungsmuster,

e) das Berechnen, für jeden elementaren Detektor, der Differenz zwischen den Bildern im realen Raum, die ausgehend vom atomistischen Modell mit Element und vom atomistischen Modell ohne Element, bezeichnet als erste Bilder, erhalten wurden,

f) das Auswählen von Bildern aus den ersten Bildern, auf denen es einen starken Kontrast in der Nähe des gegebenen Elements gibt,

g) das Kombinieren der ausgewählten Bilder, um ein zweites Bild des gegebenen Elements im gegebenen Material zu bilden.

2. Bildgebungsmethode nach Anspruch 1, die in Schritt e) den Schritt des Berechnens von dritten Bildern aufweist, die aus der Subtraktion der Bilder, die ausgehend vom atomistischen Modell ohne Element berechnet wurden, von den Bilder, die ausgehend vom atomistischen Modell mit Element berechnet wurden, resultieren und das Berechnen von vierten Bilder, die aus der Subtraktion der Bilder, die ausgehend vom atomistischen Modell mit Element berechnet wurden, von den Bildern, die ausgehend vom atomistischen Modell ohne Element berechnet wurden, resultieren und wobei der Auswahlschritt eine Auswahl zwischen den dritten und vierten Bildern ist.

3. Bildgebungsmethode nach Anspruch 1 oder 2, wobei der Kombinationsschritt die absoluten Werte der Kontraste aller ausgewählten Bilder kombiniert.

4. Bildgebungsmethode nach einem der vorangehenden Ansprüche, wobei die gewählten elementaren Detektoren ringförmige Detektoren mit Winkelakzeptanz sind, die zwischen nxl0 mrd und (n+1)×10 mrd liegt.

5. Bildgebungsmethode nach einem der vorangehenden Ansprüche, wobei die Schritte b) bis g) für jedes Element der Probe wiederholt werden.

6. Bildgebungsmethode nach einem der vorangehenden Ansprüche, wobei das Element ein chemisches Element des Periodensystems oder eine neutrale Lücke oder eine geladene Lücke ist.

7. Bildgebungsmethode nach einem der vorangehenden Ansprüche, die einen zusätzlichen Kartographieschritt mindestens einer anderen physikalischen Eigenschaft der Probe aufweist.

8. Bildgebungsmethode nach vorangehendem Anspruch, wobei der zusätzliche Kartographieschritt ein Kartographieschritt der elektrischen Felder und/oder der Magnetfelder in der Probe ist und wobei ein ringförmiger virtueller Detektor mit vier Quadranten digital bestimmt wird.

9. Bildgebungsmethode nach einem der vorangehenden Ansprüche, die nach dem Schritt d) das Berechnen eines Bildes ausgehend von einem für das Element blinden Detektor und das Berechnen der standardisierten Differenz zwischen dem in Schritt g) erhaltenen Bild, das gegenüber dem Element hypersensibel ist und dem für dieses Element blinden Bild aufweist.

10. Bildgebungsmethode nach einem der vorangehenden Ansprüche, wobei die elementaren Detektoren derart gewählt sind, dass sie für die Dicke der Probe wenig sensibel sind und/oder wobei die Methode die Integration von Filtern in die elementaren digitalen Detektoren aufweist.

11. Bildgebungsmethode nach einem der vorangehenden Ansprüche, wobei die Erfassung von Schritt a) durch Transmissions-Elektronenmikroskopie durchgeführt wird.

12. Bildgebungsmethode nach einem der vorangehenden Ansprüche, wobei das gegebene Element Wasserstoff oder eine neutrale Lücke oder eine geladene Lücke ist.

13. Differentialbildgebungsmethode, die aufweist:

- das Bilden eines zweiten Bildes durch Durchführung der Methode nach einem der Ansprüche 1 bis 12,
- das Anwenden von mindestens einer Bedingung, die mindestens die Zone der Probe verändert,
- das Bilden eines anderen zweiten Bildes der Zone durch Durchführung der Methode nach einem der Ansprüche 1 bis 12,
- die Differentialanalyse der zwei zweiten Bilder.

14. Differentialbildgebungsmethode nach Anspruch 13, wobei die auf die Probe angewendete Bedingung aus einer elektrischen Polarisierung, einer gasförmigen Umgebung und einer Temperatur gewählt ist.

15. Methode zur Erstellung eines Bildgebungsdetektors eines gegebenen Elements auf oder in einem gegebenen Material unter gegebenen experimentellen Bedingungen, die die Schritte aufweist:

a') das Erfassen von Beugungsmustern einer Vielzahl von Stellen einer gegebenen Zone der Probe durch Elektronen- oder Röntgenstrahlabtastung der gegebenen Zone unter den gegebenen experimentellen Bedingungen,

b') das Bestimmen eines atomistischen Modells zwischen dem gegebenen Element und dem gegebenen Material, wobei das atomistische Modell an jedes zu kartographierende chemische Element angepasst ist,

c') das Wählen einer Vielzahl elementarer Detektoren in Abhängigkeit vom atomistischen Modell, wobei die elementaren Detektoren digitale und nicht reale Detektoren sind,

d') das Berechnen erster Bilder der gegebenen Zone, die von der Vielzahl gewählter elementarer Detektoren ausgehend von den Beugungsmustern und dem atomistischen Modell erhalten worden wären,

e') das Auswählen der elementaren Detektoren, die durch Berechnen die Bilder von den berechneten Bildern aus den ersten Bildern gegeben haben, auf denen es einen starken Kontrast in der Nähe des gegebenen Elements gibt,

f') das Kombinieren der elementaren Detektoren, um einen Detektor zu bilden, der imstande ist, das gegebene Element im gegebenen Material bildlich darzustellen.

## Claims

1.  A method for imaging at least one given element in a given material of a sample including:

    a) acquiring diffraction patterns of a plurality of locations of a given zone of the sample by scanning, by means of an electron or X-ray beam, the given zone,
    b) determining an atomistic model between the given element and the given material, the atomistic model being adapted to each chemical element to be mapped,
    c) selecting a plurality of elementary detectors depending on the atomistic model, the elementary detectors being not real digital detectors,
    b) calculating, for each elementary detector, theoretical images, in the real-space, which are obtained from the atomistic model with an element and from the atomistic model without an element for a given instrumental physical setting and from diffraction pattern data acquired in step a),
    e) calculating, for each elementary detector, the difference between the images in the real space which are obtained from the atomistic model with an element and from the atomistic model without an element, called the first images,
    f) selecting images from the first images, on which there is a high contrast in the vicinity of the given element,
    g) combining the images selected to form a second image of the given element of the given material.

2.  The imaging method according to claim 1, including in step e), the step of calculating third images resulting from subtracting the images calculated from the atomistic model without an element from the images calculated from the atomistic model with an element, and calculating fourth images resulting from subtracting the images calculated from the atomistic model with an element from the images calculated from the atomistic model without an element, and wherein the selecting step is a selection from the third and fourth images.

3.  The imaging method according to claim 1 or 2, wherein the combining step combines absolute values of the contrasts of all the images selected.

4.  The imaging method according to one of the preceding claims, wherein the elementary detectors selected are annular detectors with an angular acceptance between $n \times 10$ mrd and $(n+1) \times 10$ mrd.

5.  The imaging method according to one of the preceding claims, wherein the steps b) to g) are repeated for each element of the sample.

6.  The imaging method according to one of the preceding claims, wherein the element is a chemical element of the periodic table or a neutral vacancy or a charged vacancy.

7.  The imaging method according to one of the preceding claims, including the additional step of mapping at least one other physical property of the sample.

8.  The imaging method according to the preceding claim, wherein the additional mapping step is a step of mapping electric fields and/or magnetic fields in the sample, and wherein a four-quadrant annular virtual detector is digitally determined.

9.  The imaging method according to one of the preceding claims, including after step d), calculating an image from a detector blind to the element, and calculating the normalised difference between the image obtained in step g) which is hypersensitive to the element and the image blind to this element.

10. The imaging method according to one of the preceding claims, wherein the elementary detectors are selected so as to be poorly sensitive to the thickness of the sample, and/or wherein the method includes integrating filters in the elementary digital detectors.

11. The imaging method according to one of the preceding claims, wherein the acquisition in step a) is performed by transmission electron microscopy.

12. The imaging method according to one of the preceding claims, wherein the given element is hydrogen or a neutral vacancy or a charged vacancy.

13. A differential imaging method including:

    - forming a second image by implementing the method according to one of claims 1 to 12,
    - applying at least one condition modifying at least said zone of the sample,

- forming another second image of said zone by implementing the method according to one of claims 1 to 12,
- differentially analysing both second images.

14. The differential imaging method according to claim 13, wherein the condition applied to the sample is selected from an electrical bias, a gaseous environment and a temperature.

15. The method for manufacturing a detector for imaging a given element on or in a given material under given experimental conditions including the steps:

a') acquiring diffraction patterns of a plurality of locations of a given zone of the sample by scanning, by means of an electron or X-ray beam, the given zone under said given experimental conditions,

b') determining an atomistic model between the given chemical element and the given material, the atomistic model being adapted to each chemical element to be mapped,

c') selecting a plurality of elementary detectors depending of the atomistic model, the elementary detectors being not real digital detectors,

d') calculating first images of the given zone which would have been obtained by the plurality of elementary detectors selected, from the diffraction patterns and the atomistic model,

e') selecting the elementary detectors having given, by calculation, the images from the images calculated from the first images, on which there is a high contrast in the vicinity of the given element,

f') combining the elementary detectors to form a detector capable of imaging the given element in the given material.

FIG.1

FIG.2

| | [0-10 mrad] | [10-20 mrad] | [20-30 mrad] | [30-40 mrad] | [40-50 mrad] | [50-60 mrad] | [60-70 mrad] |
|---|---|---|---|---|---|---|---|
| | I1 | I2 | I3 | I4 | I5 | I6 | I7 |

| [70-80 mrad] | [80-90 mrad] | [90-100 mrad] | [100-110 mrad] | [110-120 mrad] | [120-130 mrad] | [130-140 mrad] | [140-150 mrad] |
|---|---|---|---|---|---|---|---|
| I8 | I9 | I10 | I11 | I12 | I13 | I14 | I15 |

| [150-160 mrad] | [160-170 mrad] | [170-180 mrad] | [180-190 mrad] | [190-200 mrad] | [200-210 mrad] | [210-220 mrad] | [220-230 mrad] |
|---|---|---|---|---|---|---|---|
| I16 | I17 | I18 | I19 | I20 | I21 | I22 | I23 |

FIG.3

| I1' | I2' | I3' | I4' | I5' | I6' | I7' | I8' |

**FIG.4**

| I1'' | I2'' | I3'' | I4'' | I5'' | I6'' | I7'' | I8'' |

**FIG.5**

FIG.6

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **K. FUKUTANI.** Below-surface behavior of hydrogen studied by nuclear reaction analysis. *Curr. Opin. Solid State Mater. Sci.,* 2002, vol. 6, 153-161
- **J. C. MEYER ; C. O. GIRIT ; M. F. CROMMIE ; A. ZETTL.** Imaging and dynamics of light atoms and molecules on graphene. *Nature,* 2008, vol. 454, 319-322
- **J. GONNISSEN et al.** Detecting and locating light atoms from high-resolution STEM images: The quest for a single optimal design. *Ultramicroscopy,* 2016, vol. 170, 128-138
- **YI JIANG et al.** Electron ptychography of 2D materials to deep sub-ångsi-röm resolution. *Nature,* Juillet 2018, vol. 559 (7714), 343-349
- **FLORIAN F. KRAUSE.** A Realisation of Incoherent Imaging for Ultra-High Resolution TEM beyond the Classical Information Limit - Instrumentation and Methods. *European Microscopy Congress,* 20 Décembre 2016
- Conventional Transmission Electron Microscopy Imaging beyond the Diffraction and Information Limits. *Phys. Rev Lett.,* 2014, vol. 113, 096101
- **J.N. CHAPMAN ; P.E.BATSON ; E.M.WADDELL ; R.P.FERRIER.** Direct determination of magnetic domain-wall profiles by differential phase-contrast electron-microscopy. *Ultramicroscopy,* 1978, vol. 3, 203-214